# EUROPEAN PATENT APPLICATION

(11) **EP 4 303 272 A1**
(43) Date of publication of application: **10.01.2024**
(21) Application number: 22762440.0
(22) Date of filing: 25.02.2022
(51) Int. Cl.: C09D 4/02, C09D 4/00, C23C 16/50, C23C 16/515

(54) **COMPOSITE COATING, PREPARATION METHOD, AND DEVICE**

(30) Priority: 04.03.2021 CN 202110242082
(71) Applicant: Jiangsu Favored Nanotechnology Co., Ltd., Wuxi, Jiangsu 214000 (CN)
(72) Inventor: ZONG, Jian, Wuxi, Jiangsu 214000 (CN); LI, Siyue, Wuxi, Jiangsu 214000 (CN)
(74) Representative: Mewburn Ellis LLP
(86) International application number: PCT/CN2022/077853
(87) International publication number: WO 2022/183975

(57) **Abstract**

A specific implementation of the present invention provides a composite coating. In the composite coating, a coating formed by monomer plasma of a multifunctional ester having an epoxy structure and an ester coupling agent is used as a priming layer, and a coating formed by plasma of an unsaturated ester monomer having an aromatic ring and an ester coupling agent is used as an anticorrosive layer. The coating and a substrate have high bonding force and strong corrosion resistance.

## Description

This application claims the benefit of priority to Chinese Patent Application No. 202110242082.0, filed on March 4, 2021, and entitled "COMPOSITE COATING, PREPARATION METHOD, AND DEVICE", the contents of which are incorporated herein by reference in their entirety.

### TECHNICAL FIELD

The present disclosure relates to the field of plasma chemistry, and more particularly, to a plasma polymerization composite coating and a preparation method thereof.

### BACKGROUND

Electronic or electrical devices and assemblies, metal products and other various products are very sensitive to damages caused by contamination of liquids, especially contamination of water. For example, when electronic or electrical devices are in normal use or accidentally exposed to liquids, it may cause a short circuit between electronic components and cause irreparable damage to circuit boards, electronic chips and other products. Organic polymer coatings can effectively protect surfaces of different materials. Among methods for preparing organic polymer coatings, vapor deposition method is a mainstream method for preparing polymer protective coatings on surfaces of substrates. The vapor deposition method is economically practical and easy to operate. Particularly, in a plasma chemical vapor deposition, plasmas are used to activate reaction monomer gases to deposit on surfaces of substrates, and the plasma chemical vapor deposition is applicable for various substrates. In addition, the deposited polymer protective coatings are uniform, ultra-thin, transparent, insulating and anti-aging, and the deposited polymer protective coatings can selectively protect electronic components, especially printed circuit boards. Currently, plasma protective coatings have some disadvantages, such as poor binding force with substrates, prone to peeling, and unstable corrosion resistance.

### SUMMARY

Specific embodiments of the present disclosure provide a composite coating having a high binding force and a strong corrosion resistance, a preparation method and a device. Details are as follows.

A composite coating is provided, and the composite coating includes a coating I and a coating II deposited on a substrate.

The coating I is a plasma polymerization coating formed from plasmas including a monomer α and a monomer β.

The coating II is a plasma polymerization coating formed on the coating I by contacting the coating I with plasmas including a monomer γ and a monomer δ.

A structure of the monomer α is shown as in formula (1-1),

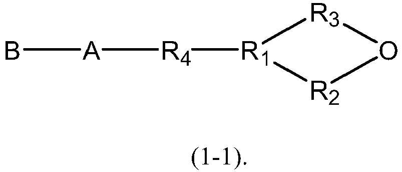

In the formula (1-1), R₁ is selected from CH or a C₃-C₈ cycloalkyl, R₂, R₃ and R₄ are respectively independently selected from a connecting bond or a C₁-C₆ alkylene, R₂ and R₃ are not connected to a same carbon atom when R₂ and R₃ are both connecting bonds, A is a connecting part, and B includes a carbon-carbon unsaturated bond or an epoxy structure.

A structure of the monomer β is shown as in formula (2-1),

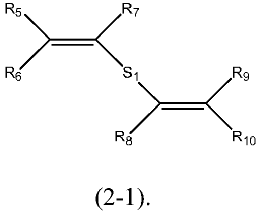

In the formula (2-1), S₁ includes at least one -O-C(O)- or -C(O)-O-, and R₅, R₆, R₇, R₈, R₉ and R₁₀ are respectively independently selected from a group consisting of a hydrogen atom, a halogen atom, a C₁-C₁₀ alkyl and a halogen-substituted C₁-C₁₀ alkyl.

A structure of the monomer γ is shown as in formula (3-1),

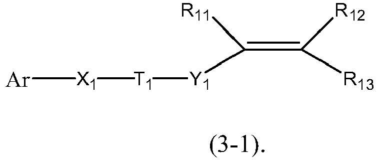

In the formula (3-1), Ar is a structure with aromatic ring(s), T₁ is -O-C(O)- or -C(O)-O-, X₁ is a connecting part, Y₁ is a connecting part, and R₁₁, R₁₂ and R₁₃ are respectively independently selected from a group consisting of a hydrogen atom, a halogen atom, a C₁-C₁₀ alkyl and a halogen-substituted C₁-C₁₀ alkyl.

A structure of the monomer δ is shown as in formula (4-1),

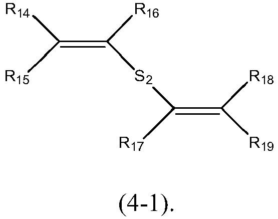

In the formula (4-1), S₂ includes at least one -O-C(O)- or -C(O)-O-, and R₁₄, R₁₅, R₁₆, R₁₇, R₁₈ and R₁₉ are respectively independently selected from a group consisting of a hydrogen atom, a halogen atom, a C₁-C₁₀ alkyl and a halogen-substituted C₁-C₁₀ alkyl.

Optionally, the A is -O-C(O)- or -C(O)-O-.

Optionally, a structure of the monomer α is shown as in formula (1-2),

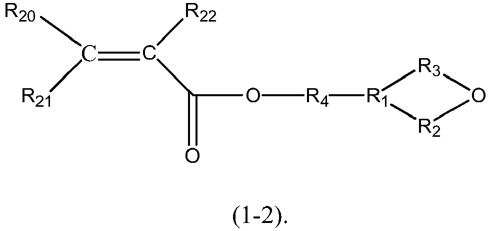

In the formula (1-2), R₂₀, R₂₁ and R₂₂ are respectively independently selected from a group consisting of a hydrogen atom, a halogen atom, a C₁-C₁₀ alkyl and a halogen-substituted C₁-C₁₀ alkyl.

Optionally, the R₅, R₆, R₇, R₈, R₉, R₁₀, R₁₁, R₁₂, R₁₃, R₁₄, R₁₅, R₁₆, R₁₇, R₁₈ and R₁₉ are respectively independently selected from a group consisting of a hydrogen atom and a methyl.

Optionally, the R₂₀, R₂₁ and R₂₂ are respectively independently selected from a group consisting of a hydrogen atom and a methyl.

Optionally, the monomer α includes one or more selected from a group consisting of: glycidyl methacrylate, tetrahydrofurfuryl acrylate, 3,4-epoxycyclohexylmethyl-3,4-epoxycyclohexylcarboxylate, 3,4-epoxycyclohexylmethacrylate, 3,4-epoxycyclohexylmethylmethacrylate, 1,2-epoxy-4-vinylcyclohexane, bis (2,3-epoxycyclopentyl) ether, 2,3-epoxycyclopentylcyclopentyl ether, vinylcyclohexene diepoxide, diisoprene diepoxide and bis ((3,4-epoxycyclohexyl) methyl) adipate.

Optionally, the S₁ and/or S₂ include(s) two -O-C(O)- or -C(O)-O-.

Optionally, a structure of the S₁ is shown as in formula (2-2),

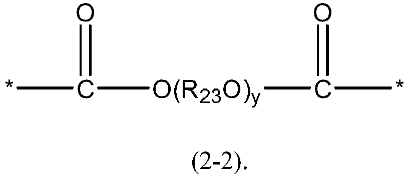

In the formula (2-2), R₂₃ is a C₂-C₁₀ alkylene or a halogen-substituted C₂-C₁₀ alkylene, and y is an integer ranging from 0 to 10.

Optionally, the monomer β includes at least one selected from a group consisting of: 1,4-butanediol dimethacrylate, 1,6-hexanediol dimethacrylate, ethylene glycol dimethacrylate, diethylene glycol dimethacrylate, triethylene glycol dimethacrylate, tetraethylene glycol dimethacrylate, 1,3-butanediol dimethacrylate, neopentyl glycol dimethacrylate, methacrylic anhydride, diprop-2-enyl-2-methylene succinate, diprop-2-enyl 2-benzylidene malonate, and diethyl diallyl malonate.

Optionally, a structure of the X₁ is shown as in formula (3-2),

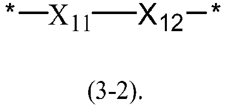

In the formula (3-2), X₁₁ is a connecting bond, -O- or -C(O)-, and X₁₂ is a connecting bond, a C₁-C₁₀ alkylene or a halogen-substituted C₁-C₁₀ alkylene.

The Y₁ is a connecting bond, a C₁-C₁₀ alkylene or a halogen-substituted C₁-C₁₀ alkylene.

Optionally, the Ar is a benzene ring structure or a benzene ring structure with substituent(s).

Optionally, a structure of the monomer γ is shown as in formula (3-3),

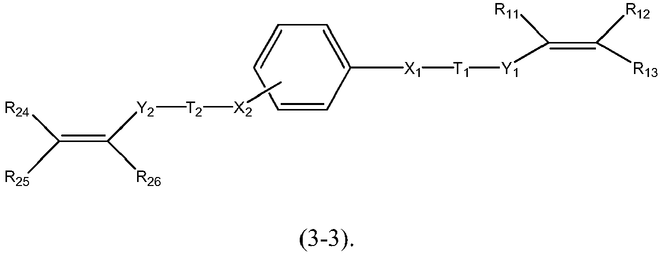

In the formula (3-3), T₂ is -O-C(O)- or -C(O)-O-, X₂ is a connecting part, and Y₂ is a connecting part. R₂₄, R₂₅ and R₂₆ are respectively independently selected from a group consisting of a hydrogen atom, a halogen atom, a C₁-C₁₀ alkyl and a halogen-substituted C₁-C₁₀ alkyl.

Optionally, a structure of the X₂ is shown as in formula (3-4),

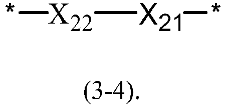

In the formula (3-4), X₂₁ is a connecting bond, -O- or -C(O)-, and X₂₂ is a connecting bond, a C₁-C₁₀ alkylene or a halogen-substituted C₁-C₁₀ alkylene.

The Y₂ is a connecting bond, a C₁-C₁₀ alkylene or a halogen-substituted C₁-C₁₀ alkylene.

Optionally, the R₂₄, R₂₅ and R₂₆ are respectively independently selected from a group consisting of a hydrogen atom and a methyl.

Optionally, the monomer γ includes at least one selected from a group consisting of: 2-phenoxyethyl acrylate, phenyl acrylate, diallyl terephthalate and phenyl methacrylate.

Optionally, a structure of the S₂ is shown as in formula (4-2),

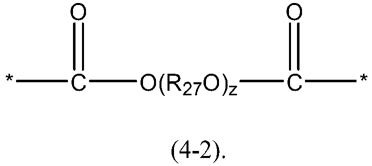

In the formula (4-2), R₂₇ is a C₂-C₁₀ alkylene or a halogen-substituted C₂-C₁₀ alkylene, and z is an integer ranging from 0 to 10.

Optionally, the monomer δ includes at least one selected from a group consisting of: 1,4-butanediol dimethacrylate, 1,6-hexanediol dimethacrylate, ethylene glycol dimethacrylate, diethylene glycol dimethacrylate, triethylene glycol dimethacrylate, tetraethylene glycol dimethacrylate, 1,3-butanediol dimethacrylate, neopentyl glycol dimethacrylate, methacrylic anhydride, dipropyl-2-allyl-2-methylene succinate, diprop-2-enyl 2-benzylidene malonate, and diethyl diallyl malonate.

Optionally, the composite coating also includes a coating III. The coating III is a plasma polymerization coating formed on the coating II by contacting the coating II with plasmas including a monomer ε.

A structure of the monomer ε is shown as in formula (5-1),

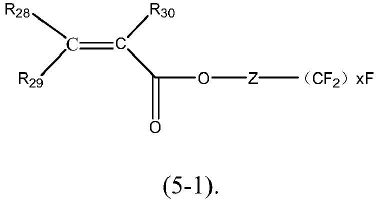

In the formula (5-1), Z is a connecting part, R₂₈, R₂₉ and R₃₀ are respectively independently selected from a group consisting of a hydrogen atom, a halogen atom, a C₁-C₁₀ hydrocarbyl and a halogen-substituted C₁-C₁₀ hydrocarbyl, and x is an integer ranging from 1 to 20.

Optionally, the Z is a connecting bond, a C₁-C₄ alkylene or a C₁-C₄ alkylene with substituent(s), and x is an integer greater than or equal to 5.

Optionally, the R₂₈, R₂₉ and R₃₀ are respectively independently selected from a group consisting of a hydrogen atom and a methyl.

Optionally, the monomer ε includes one or more selected from a group consisting of: 3-(perfluoro-5-methylhexyl)-2-hydroxypropyl methacrylate, 2-(perfluorodecyl) ethyl methacrylate, 2-(perfluorohexyl) ethyl methacrylate, 2-(perfluorododecyl) ethyl acrylate, 2-perfluorooctyl ethyl acrylate, 1H,1H,2H,2H-perfluorooctyl acrylate, 2-(perfluorobutyl) ethyl acrylate, (2H-perfluoropropyl)-2-acrylate, and (perfluorocyclohexyl) methacrylate.

Optionally, a thickness of the composite coating ranges from 50nm to 300nm.

Optionally, a molar ratio of the monomer α and the monomer β ranges from 1:5 to 5:1.

Optionally, a molar ratio of the monomer γ and the monomer δ ranges from 3:10 to 10:3.

Optionally, the substrate is a metal, a plastic, a fabric, a glass, an electrical assembly, an optical instrument or an electrical component.

A preparation method of any one of the above composite coatings is provided. The preparation method includes:
providing a substrate, placing the substrate in a plasma reaction chamber, vacuumizing the plasma reaction chamber to get a vacuum degree in the plasma reaction chamber ranging from 20mTorr to 200mTorr, and introducing one or more gases selected from a group consisting of inert gas He, inert gas Ar, and O₂;
introducing mixed vapors including the monomer α and the monomer β into the plasma reaction chamber, and turning on a plasma discharge to form a plasma polymerization coating I; and
introducing mixed vapors including the monomer γ and the monomer δ into the plasma reaction chamber, and turning on a plasma discharge to form a plasma polymerization coating II on the coating I.

Optionally, introducing a vapor of the monomer ε into the plasma reaction chamber, and turning on a plasma discharge to form a plasma polymerization coating III on the coating II.

Optionally, the plasma is a pulse plasma.

Optionally, the pulse plasma is generated by applying a pulse voltage discharge, wherein a pulse power ranges from 50W to 500W, a pulse frequency ranges from 25Hz to 85kHz, a pulse duty cycle ranges from 5% to 85%, and a plasma discharge duration time ranges from 100s to 36000s.

A device is provided. At least a part of a surface of the device is provided with any one of the above composite coatings.

According to some embodiments of the present disclosure, a plasma of a multifunctional-group monomer having an epoxy structure and a plasma of an ester-based coupling agent are used to form a coating as a base coating, and a plasma of an unsaturated ester-based monomer having aromatic ring(s) and a plasma of an ester-based coupling agent are used to form a coating as an anti-corrosion coating. The base coating is conducive to a close combination of the substrate and the anti-corrosion coating and improving a compactness of the composite coating. In the anti-corrosion coating the aromatic ring(s) has a good stability, which can provide the polymer with a relatively good hardness, a relatively good heat resistance, a relatively good temperature resistance, an improved hydrophobicity, and a decreased water solubility. Ester groups are provided in the anti-corrosion coating to form hydrogen bonds, resulting in a relatively good adhesion. Therefore, the composite coating being of a very thin thickness has an excellent protective performance. Further, a multifunctional-group monomer having an epoxy structure uses a multifunctional-group ester having an epoxy structure, particularly an acrylate having an epoxy structure, leading to an even better protective performance of the entire composite coating. Further, a fluorine-containing hydrophobic coating is formed on the anti-corrosion coating, and may further improve the protective performance of the composite coating.

### BRIEF DESCRIPTION OF THE DRAWINGS

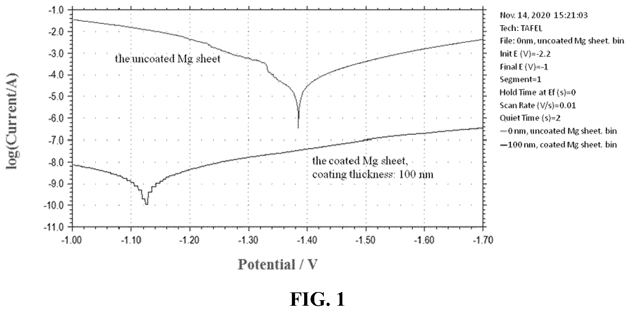

FIG. 1 schematically illustrates a Tafel curve obtained from an electrochemical test for a coated Mg sheet and an uncoated Mg sheet in Embodiment 3.

### DETAILED DESCRIPTION

According to some embodiments of the present disclosure, a composite coating includes a coating I and a coating II deposited on a substrate.

The coating I is a plasma polymerization coating formed from plasmas including a monomer α and a monomer β.

The coating II is a plasma polymerization coating formed on the coating I by contacting the coating I with plasmas including a monomer γ and a monomer δ.

A structure of the monomer α is shown as in formula (1-1),

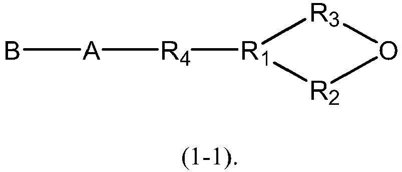

In the formula (1-1), R₁ is selected from CH or a C₃-C₈ cycloalkyl, R₂, R₃ and R₄ are respectively independently selected from a connecting bond or a C₁-C₆ alkylene, and R₂ and R₃ are not connected to a same carbon atom when R₂ and R₃ are both connecting bonds, A is a connecting part, and B includes a carbon-carbon unsaturated bond or an epoxy structure.

A structure of the monomer β is shown as in formula (2-1),

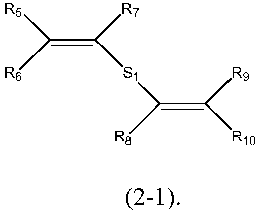

In the formula (2-1), S₁ includes at least one -O-C(O)- or -C(O)-O-, and R₅, R₆, R₇, R₈, R₉ and R₁₀ are respectively independently selected from a group consisting of a hydrogen atom, a halogen atom, a C₁-C₁₀ alkyl and a halogen-substituted C₁-C₁₀ alkyl.

A structure of the monomer γ is shown as in formula (3-1),

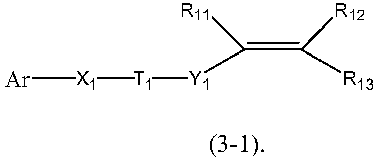

In the formula (3-1), Ar is a structure with aromatic ring(s), T₁ is -O-C(O)- or -C(O)-O-, X₁ is a connecting part, Y₁ is a connecting part, and R₁₁, R₁₂ and R₁₃ are respectively independently selected from a group consisting of a hydrogen atom, a halogen atom, a C₁-C₁₀ alkyl and a halogen-substituted C₁-C₁₀ alkyl.

A structure of the monomer δ is shown as in formula (4-1),

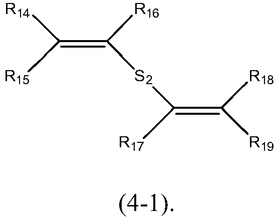

In the formula (4-1), S₂ includes at least one -O-C(O)- or -C(O)-O-, and R₁₄, R₁₅, R₁₆, R₁₇, R₁₈ and R₁₉ are respectively independently selected from a group consisting of a hydrogen atom, a halogen atom, a C₁-C₁₀ alkyl and a halogen-substituted C₁-C₁₀ alkyl.

According to some embodiments of the present disclosure, R₂ and R₃ are not connected to a same carbon atom when R₂ and R₃ are both connecting bonds. Specifically, when R₁ is CH, at least one of R₂ and R₃ is not a connecting bond. When R₁ is a cycloalkyl, R₂ and R₃ share two carbon atoms with R₁. Or, when R₂ and R₃ share a carbon atom with R₁, at least one of R₂ and R₃ is not a connecting bond.

According to some embodiments of the present disclosure, the coating I is formed on the substrate by performing a plasma chemical vapor deposition of the multifunctional-group monomer α having an epoxy structure as shown in the formula (1-1) and the ester-based coupling agent monomer β as shown in the formula (1-2), so that the substrate having the composite coating may be tightly combined with an anti-corrosion coating. The coating II is formed on the coating I by performing a plasma chemical vapor deposition of the unsaturated ester-based monomer γ having aromatic ring(s) as shown in the formula (1-3) and an ester-based coupling agent monomer δ as shown in the formula (1-4). The aromatic ring has a good stability, which can provide the polymer coating with a relatively good hardness, a relatively good heat resistance, a relatively good temperature resistance, an improved hydrophobicity, and a decreased water solubility. Ester groups are provided in the coating II to cooperate with ester bonds of the coating I to form hydrogen bonds, resulting in a good adhesion. Therefore, the composite coating being of a very thin thickness has an excellent protective performance.

According to some embodiments of the present disclosure, the R₅, R₆, R₇, R₈, R₉, R₁₀, R₁₁, R₁₂, R₁₃, R₁₄, R₁₅, R₁₆, R₁₇, R₁₈ and R₁₉ are respectively independently selected from a group consisting of a hydrogen atom and a methyl.

According to some embodiments of the present disclosure, R₁ is selected from a C₃-C₈ cycloalkyl, such as a cyclopentyl or a cyclohexyl, and the R₂ and the R₃ share two carbon atoms with R₁. The R₂, R₃ and R₄ are respectively independently selected from a connecting bond or a C₁-C₆ alkylene. The alkylene includes a linear alkylene, such as methylene, ethylene, propylene, or butylene. Or the alkylene includes a branched alkylene, such as isopropylene or isobutylene.

According to some embodiments of the present disclosure, in the formula (1-1), B is a carbon-carbon unsaturated double bond, a carbon-carbon unsaturated triple bond or an epoxy structure, and the epoxy structure is conductive to forming a dense coating. According to some embodiments, the A is -O-C(O)- or -C(O)-O-. Further, a structure of the monomer α is shown as in formula (1-2),

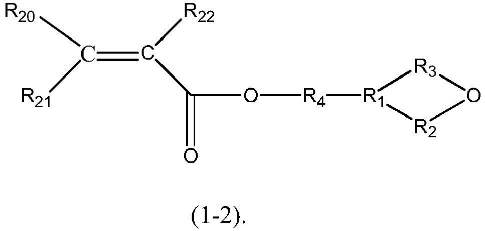

In the formula (1-2), R₂₀, R₂₁ and R₂₂ are respectively independently selected from a group consisting of a hydrogen atom, a halogen atom, a C₁-C₁₀ alkyl and a halogen-substituted C₁-C₁₀ alkyl. The composite coating formed from the monomer α having this structure has a relatively good protective performance. According to some embodiments, the R₂₀, R₂₁ and R₂₂ are respectively independently selected from a group consisting of a hydrogen atom and a methyl. The alkyl includes a linear alkyl, such as methyl, ethyl, propyl, or butyl. Or the alkyl includes a branched alkyl, such as isopropyl or isobutyl.

According to some embodiments of the present disclosure, the monomer α includes one or more selected from a group consisting of: glycidyl methacrylate (CAS number: 106-91-2), tetrahydrofurfuryl acrylate (CAS number: 2399-48-6), 3,4-epoxycyclohexylmethyl-3,4-epoxycyclohexylcarboxylate (CAS number: 2386-87-0), 3,4-epoxycyclohexylmethacrylate (CAS number: 64630-63-3), 3,4-epoxycyclohexylmethylmethacrylate (CAS number: 82428-30-6), 1,2-epoxy-4-vinylcyclohexane (CAS number: 106-86-5), bis (2,3-epoxycyclopentyl) ether (CAS number: 2386-90-5), 2,3-epoxycyclopentylcyclopentyl ether, vinylcyclohexene diepoxide (CAS number: 106-87-6), diisoprene diepoxide and bis ((3,4-epoxycyclohexyl) methyl) adipate (CAS number: 3130-19-6).

According to some embodiments of the present disclosure, the S₁ includes two -O-C(O)- or -C(O)-O-. That is, the S₁ includes two -O-C(O)-, or the S₁ includes two -C(O)-O-, or the S₁ includes a -O-C(O)- and a -C(O)-O-.

According to some embodiments of the present disclosure, a structure of the S₁ is shown as in formula (2-2),

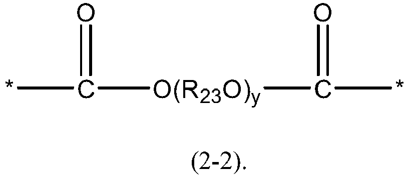

In the formula (2-2), R₂₃ is a C₂-C₁₀ alkylene or a halogen-substituted C₂-C₁₀ alkylene, the alkylene includes a linear alkylene, such as methylene, ethylene, propylene, or butylene. Or the alkylene includes a branched alkylene, such as isopropylene or isobutylene. In the formula (2-2), y is an integer ranging from 0 to 10, and specifically, y is 0, 1, 2, 3, 4, 5, 6, 7, 8, 9, or 10.

According to some embodiments of the present disclosure, as a specific non-limiting example, the monomer β includes at least one selected from a group consisting of: 1,4-butanediol dimethacrylate (CAS number: 2082-81-7), 1,6-hexanediol dimethacrylate (CAS number: 6606-59-3), ethylene glycol dimethacrylate (CAS number: 97-90-5), diethylene glycol dimethacrylate (CAS number: 2358-84-1), triethylene glycol dimethacrylate (CAS number: 109-16-0), tetraethylene glycol dimethacrylate (CAS number: 109-17-1), 1,3-butanediol dimethacrylate (CAS number: 1189-08-8), neopentyl glycol dimethacrylate (CAS number: 1985-51-9), methacrylic anhydride (CAS number: 760-93-0), diprop-2-enyl-2-methylene succinate, diprop-2-enyl 2-benzylidene malonate (CAS number: 52505-39-2), and diethyl diallyl malonate (CAS number: 3195-24-2).

According to some embodiments, the Ar is a benzene ring with substituent(s) on the aromatic ring or a heteroaromatic ring with substituent(s) on the aromatic ring(s). According to some embodiments, the Ar is a benzene ring without substituent(s) on the aromatic ring or a heteroaromatic ring without substituent(s) on the aromatic ring(s).

According to some embodiments of the present disclosure, X₁ is a connecting part, and Y₁ is a connecting part. X₁ is used to connect Ar having aromatic ring(s) with the ester bond T₁, and Y₁ is used to connect the ester bond T₁ with the carbon-carbon unsaturated double bond. According to some embodiments, a structure of the X₁ is shown as in the formula (3-2) below,

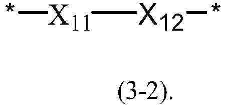

In the formula (3-2), X₁₁ is a connecting bond, -O- or -C(O)-, and X₁₂ is a connecting bond, a C₁-C₁₀ alkylene or a halogen-substituted C₁-C₁₀ alkylene. The Y₁ is a connecting bond, a C₁-C₁₀ alkylene or a halogen-substituted C₁-C₁₀ alkylene. The alkylene includes a linear alkylene, such as methylene, ethylene, propylene, or butylene. Or the alkylene includes a branched alkylene, such as isopropylene or isobutylene.

According to some embodiments of the present disclosure, a structure of the monomer γ is shown as in formula (3-3),

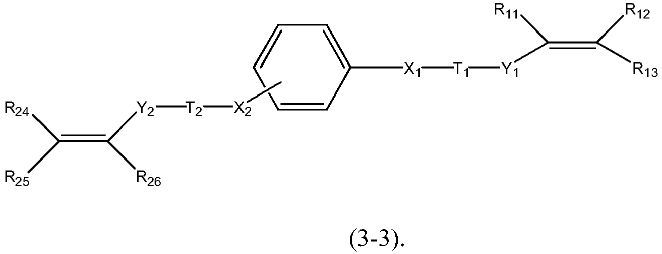

In the formula (3-3), T₂ is -O-C(O)- or -C(O)-O-. X₂ is a connecting part used to connect the benzene ring with the ester bond T₂, and Y₂ is a connecting part used to connect the ester bond T₂ with the carbon-carbon double bond.

R₂₄, R₂₅ and R₂₆ are respectively independently selected from a group consisting of a hydrogen atom, a halogen atom, a C₁-C₁₀ alkyl and a halogen-substituted C₁-C₁₀ alkyl. The alkyl includes a linear alkyl, such as methyl, ethyl, propyl, or butyl. Or the alkyl includes a branched alkyl, such as isopropyl or isobutyl.

According to some embodiments of the present disclosure, in the structure shown in the formula (3-3), two substituents on the benzene ring may be para-substituents, and in other embodiments, two substituents may be ortho-substituents or meta-substituents.

According to some embodiments of the present disclosure, a structure of the X₂ is shown as in the formula (3-4) below,

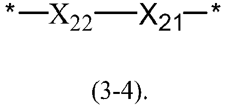

In the formula (3-4), X₂₁ is a connecting bond, -O- or -C(O)-, and X₂₂ is a connecting bond, a C₁-C₁₀ alkylene or a halogen-substituted C₁-C₁₀ alkylene. The Y₂ is a connecting bond, a C₁-C₁₀ alkylene or a halogen-substituted C₁-C₁₀ alkylene. The alkylene includes a linear alkylene, such as methylene, ethylene, propylene, or butylene. Or the alkylene includes a branched alkylene, such as isopropylene or isobutylene.

According to some embodiments of the present disclosure, the R₂₄, R₂₅ and R₂₆ are respectively independently selected from a group consisting of a hydrogen atom and a methyl.

According to some embodiments of the present disclosure, as a specific non-limiting example, the monomer γ includes at least one selected from a group consisting of: 2-phenoxyethyl acrylate (CAS number: 48145-04-6), phenyl acrylate (CAS number: 937-41-7), diallyl terephthalate (CAS number: 1026-92-2) and phenyl methacrylate (CAS number: 2177-70-0).

According to some embodiments of the present disclosure, the S₂ includes two -O-C(O)- or -C(O)-O-. That is, S₂ includes two -O-C(O)-, or S₂ includes two - C(O)-O-, or S₂ includes a -O-C(O)- and a -C(O)-O-.

According to some embodiments of the present disclosure, a structure of the S₂ is shown as in formula (4-2),

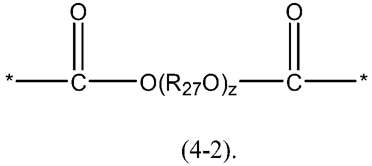

In the formula (4-2), R₂₇ is a C₂-C₁₀ alkylene or a halogen-substituted C₂-C₁₀ alkylene. The alkylene includes a linear alkylene, such as methylene, ethylene, propylene, or butylene. Or the alkylene includes a branched alkylene, such as isopropylene or isobutylene. In the formula (4-2), z is an integer ranging from 0 to 10, and specifically, z is 0, 1, 2, 3, 4, 5, 6, 7, 8, 9, or 10.

According to some embodiments of the present disclosure, as a specific non-limiting example, the monomer δ includes at least one selected from a group consisting of: 1,4-butanediol dimethacrylate, 1,6-hexanediol dimethacrylate, ethylene glycol dimethacrylate, diethylene glycol dimethacrylate, triethylene glycol dimethacrylate, tetraethylene glycol dimethacrylate, 1,3-butanediol dimethacrylate, neopentyl glycol dimethacrylate, methacrylic anhydride, dipropyl-2-allyl-2-methylene succinate, diprop-2-enyl 2-benzylidene malonate, and diethyl diallyl malonate.

According to some embodiments of the present disclosure, the composite coating also includes a coating III. The coating III is a plasma polymerization coating formed on the coating II by contacting the coating II with plasmas including a monomer ε. A structure of the monomer ε is shown as in formula (5-1),

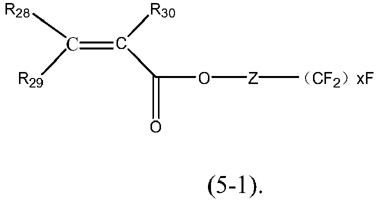

In the formula (5-1), Z is a connecting part, R₂₈, R₂₉ and R₃₀ are respectively independently selected from a group consisting of a hydrogen atom, a halogen atom, a C₁-C₁₀ hydrocarbyl and a halogen-substituted C₁-C₁₀ hydrocarbyl, and x is an integer ranging from 1 to 20.

According to some embodiments of the present disclosure, the Z is a connecting part used to connect an ester bond with a perfluorocarbon alkyl. According to some embodiments, the Z is a connecting bond, a C₁-C₄ alkylene or a C₁-C₄ alkylene with substituent(s). The alkylene includes a linear alkylene, such as methylene, ethylene, propylene, or butylene. Or the alkylene includes a branched alkylene, such as isopropylene or isobutylene. The substituent(s) include(s): a halogen atom, a hydrocarbyl, a carboxyl, or an ester group, etc.

According to some embodiments of the present disclosure, the x is an integer greater than or equal to 4, and further the x is an integer greater than or equal to 6. Specifically, the x is such as 6, 7, 8, 9, 10, 11, 12, 13, 14, 15, 16, 17, 18, 19 or 20, and is beneficial for improving a hydrophobicity performance of the coating.

According to some embodiments of the present disclosure, as a specific non-limiting example, the monomer ε includes one or more selected from a group consisting of: 3-(perfluoro-5-methylhexyl)-2-hydroxypropyl methacrylate (CAS number: 16083-81-1), 2-(perfluorodecyl) ethyl methacrylate (CAS number: 2144-54-9), 2-(perfluorohexyl) ethyl methacrylate (CAS number: 2144-53-8), 2-(perfluorododecyl) ethyl acrylate (CAS number: 34395-24-9), 2-perfluorooctyl ethyl acrylate (CAS number: 27905-45-9), 1H,1H,2H,2H-perfluorooctyl acrylate (CAS number: 17527-29-6), 2-(perfluorobutyl) ethyl acrylate (CAS number: 52591-27-2), (2H-perfluoropropyl)-2-acrylate (CAS number: 59158-81-5), and (perfluorocyclohexyl) methacrylate (CAS number: 40677-94-9).

According to some embodiments of the present disclosure, the coating I is a plasma polymerization coating formed from plasmas including the monomer α and the monomer β. The coating II is a plasma polymerization coating formed on the coating I by contacting the coating I with plasmas including the monomer γ and the monomer δ. The coating III is a plasma polymerization coating formed on the coating II by contacting the coating II with a plasma of the monomer ε. According to some embodiments, without affecting the overall performance of the coating I, the coating II, or the coating III, the coating I may be a plasma polymerization coating formed from plasmas including the monomer α, the monomer β and other suitable monomer(s). The coating II may be a plasma polymerization coating formed on the coating I by contacting the coating I with plasmas including the monomer γ, the monomer δ and other suitable monomer(s). The coating III may be a plasma polymerization coating formed on the coating II by contacting the coating II with plasmas including the monomer ε and other suitable monomer(s).

According to some embodiments of the present disclosure, a thickness of the composite coating ranges from 50nm to 500nm. The composite coating can still maintain an excellent protective performance though having such an ultra-thin thickness. According to some embodiments, the substrate is a metal, and a thickness of the composite coating ranges from 80nm to 150nm, and specifically may be, for example, 80nm, 90nm, 100nm, 110nm, 120nm, 130nm, 140nm, or 150nm, and so on. According to some embodiments, the substrate is a circuit board, and a thickness of the composite coating ranges from 200nm to 300nm, and specifically may be, for example, 200nm, 210nm, 220nm, 230nm, 240nm, 250nm, 260nm, 270nm, 280nm, 290nm or 300nm, and so on.

According to some embodiments of the present disclosure, a molar ratio of the monomer α and the monomer β ranges from 1:5 to 5:1, and specifically may be such as 1:5, 1:4, 1:3, 1:2.5, 1:2, 1:1.5, 1:1, 1.5:1, 2:1, 2.5:1, 3:1, 4:1 or 5:1. According to some other embodiments, the molar ratio of the monomer α and the monomer β can also be adjusted between other ratios depending on specific monomers situations and specific product protection requirements.

According to some embodiments of the present disclosure, a molar ratio of the monomer γ and the monomer δ ranges from 3:10 to 10:3, and specifically may be such as 3:10, 4:10, 5:10, 6:10, 7:10, 8:10, 9:10, 10:10, 10:9, 10:8, 10:7, 10:6, 10:5, 10:4 or 10:3. According to some other embodiments, the molar ratio of the monomer γ and the monomer δ can also be adjusted between other ratios depending on specific monomers situations and specific product protection requirements.

According to some embodiments of the present disclosure, the substrate is a metal, such as iron, magnesium, aluminum, copper or alloy(s) thereof. According to some other embodiments, the substrate is various plastics, fabrics, glass, electrical assemblies, or optical instruments, and so on. Specifically, the electrical assemblies may be printed circuit boards (PCBs), electronic products, or electronic assembly semi-finished products. When the substrate is an electronic product, the electronic product may be, for example, but is not limited to, a mobile phone, a tablet, a keyboard, an electronic reader, a wearable device, a display, and so on. The substrate may also be any suitable electrical component of an electrical assembly, and specifically, the electrical component may be a resistor, a capacitor, a transistor, a diode, an amplifier, a relay, a transformer, a battery, a fuse, an integrated circuit, a switch, an LED, an LED display, a piezoelectric component, an optoelectronic component, an antenna or an oscillator, and so on.

According to some embodiments of the present disclosure, a preparation method of any one of the above composite coatings is provided. The preparation method includes:
providing a substrate, placing the substrate in a plasma reaction chamber, vacuumizing the plasma reaction chamber to get a vacuum degree in the plasma reaction chamber ranging from 20mTorr to 200mTorr, and introducing one or more gases selected from a group consisting of inert gas He, inert gas Ar, and O₂;
introducing mixed vapors including the monomer α and the monomer β into the plasma reaction chamber, and turning on a plasma discharge to form a plasma polymerization coating I; and
introducing mixed vapors including the monomer γ and the monomer δ into the plasma reaction chamber, and turning on a plasma discharge to form a plasma polymerization coating II on the coating I.

According to some embodiments of the present disclosure, the preparation method also includes: introducing a vapor of the monomer ε into the plasma reaction chamber, and turning on a plasma discharge to form a plasma polymerization coating III on the coating II.

According to some embodiments of the present disclosure, the monomer α, the monomer β, the monomer γ, the monomer δ, the monomer ε, the coating I, the coating II, the coating III and the substrate are as described above.

According to some embodiments of the present disclosure, in order to further enhance the adhesion between the plasma coating and the substrate, the substrate is pretreated by a continuous wave plasma. Specifically, in an inert gas atmosphere, a plasma discharge is turned on, and the plasma discharge power ranges from 50W to 500W, and specifically may be such as 50W, 100W, 150W, 200W, 250W, 300W, 350W, 400W, 450W, or 500W. A discharge duration time ranges from 30s to 600s, and specifically may be such as 30s, 50s, 100s, 200s, 300s, 400s, 500s, or 600s. According to some other embodiments, the substrate is pretreated by heat, oxygen, or high-energy radiation, etc.

According to some embodiments of the present disclosure, the plasma is a pulse plasma. A flow rate of the monomer ranges from 50µL/min to 500µL/min, and specifically may be such as 100µL/min, 200µL/min, 300µL/min, or 400µL/min. A vaporization temperature of the monomer ranges from 50°C to 120°C, and specifically may be such as 50°C, 60°C, 70°C, 80°C, 90°C, 100°C, 110°C, or 120°C. The vaporization occurs under vacuum conditions, and the pulse plasma is generated by applying a pulse voltage discharge. The pulse power ranges from 50W to 500W, and specifically may be such as 50W, 100W, 150W, 200W, 250W, 300W, 350W, 400W, 450W, or 500W. A pulse frequency ranges from 25Hz to 85kHz, and specifically may be such as 25Hz, 30 Hz, 35Hz, 40Hz, 45Hz, 50Hz, 55Hz, 60Hz, 65Hz, 70Hz, 75Hz, 80Hz, or 85Hz. A pulse duty cycle ranges from 5% to 85%, and specifically may be such as 5%, 10%, 15%, 20%, 25%, 30%, 35%, 40%, 45%, 50%, 55%, 60%, 65%, 70%, 75%, 80% or 85%. A plasma discharge duration time ranges from 100s to 36000s, and specifically may be such as 100s, 200s, 500s, 1000s, 2000s, 3000s, 4000s, 5000s, 6000s, 7000s, 8000s, 9000s, 10000s, 15000s, 20000s, 25000s, 30000s, 36000s.

According to some embodiments of the present disclosure, the plasma discharge methods may be various conventional discharge methods, for example, electrodeless discharge (e.g., radio frequency inductively coupled discharge, microwave discharge), single-electrode discharge (e.g., corona discharge, plasma jet formed by single-electrode discharge), two-electrode discharge (e.g., dielectric barrier discharge, exposed electrode radio frequency glow discharge) and multi-electrode discharge (e.g., discharge using a floating electrode as a third electrode).

A device is also provided by some embodiments of the present disclosure. At least part of the surface of the device is provided with any one of the aforementioned composite coatings. According to some embodiments, the aforementioned protective coating is formed on part of or all of the surface of the device.

The present disclosure is further described in the following specific embodiments.

### Embodiments

### Description of test methods

The 20.5V underwater power-on test: the test process was as follows: 1. a 20.5V voltage was provided for circuit boards by a power supply; 2. the circuit boards were soaked in water; 3. the current was detected by a computer; 4. the failure time (current > 0.6mA) was recorded.

Salt spray test: the test was performed according to GB/T 2423.18-2000 environmental test method for electrical and electronic products.

Coating thickness test: an American Filmetrics F20-UV film thickness measuring instrument was used for testing.

Electrochemical test: a Shanghai Chenhua CHI660E C20704 electrochemical analyzer was used for testing a polarization curve in a 3.6% NaCl neutral solution. Test conditions included: a corrosion potential ranged from -600mv to +600mv, a scanning rate was 0.00033mv/s, and the scanning duration time was 600s.

### Embodiment 1

A circuit board, a Mg sheet and a Fe sheet were placed in a plasma chamber, the chamber was vacuumized to 40mTorr, and helium gas was introduced at a flow rate of 60sccm. A radio frequency plasma discharge was turned on to pretreat the substrates, the discharge power in this pretreatment stage was 150W, and the discharge duration time was 600s.

Thereafter, a mixture of a monomer of 1,4-butanediol diacrylate and a monomer of tetrahydrofurfuryl acrylate (the mass ratio was 2:1) was introduced and vaporized at a vaporization temperature of 100°C and then was introduced into the chamber for plasma chemical vapor deposition. The flow rate of the mixture was 150µL/min. Plasmas in the chamber were generated by a radio frequency discharge, and the output mode was pulse. The discharge power was 50W, the frequency was 45Hz, the pulse duty cycle was 25%, and the discharge duration time was 3600s.

Thereafter, a mixture of a monomer of 1,6-hexanediol diacrylate and a monomer of phenyl methacrylate (the mass ratio was 1:1) was introduced and vaporized at a vaporization temperature of 120°C and then was introduced into the chamber for plasma chemical vapor deposition. The flow rate of the mixture was 100µL/min. Plasmas in the chamber were generated by a radio frequency discharge, and the output mode was pulse. The discharge power was 20W, the frequency was 25Hz, the pulse duty cycle was 65%, and the discharge duration time was 7200s.

Thereafter, a monomer of 3-(perfluoro-5-methylhexyl)-2-hydroxypropyl methacrylate was introduced and vaporized at a vaporization temperature of 120°C and then was introduced into the chamber for plasma chemical vapor deposition. The flow rate of the monomer was 100µL/min. Plasmas in the chamber were generated by a radio frequency discharge, and the output mode was pulse. The discharge power was 180W, the frequency was 35Hz, the pulse duty cycle was 45%, and the discharge duration time was 7200s.

After coating, the compressed air was introduced to restore the chamber to normal pressure. The circuit board was taken out for the 20.5 V underwater power-on test. The Mg sheet and the Fe sheet were taken out for the salt spray test. The test results are listed in Table 1.

### Embodiment 2

A circuit board, a Mg sheet and a Fe sheet were placed in a plasma chamber, the chamber was vacuumized to 8mTorr, and helium gas was introduced at a flow rate of 80sccm. A radio frequency plasma discharge was turned on to pretreat the substrates, the discharge power in this pretreatment stage was 180W, and the discharge duration time was 300s.

Thereafter, a mixture of a monomer of triethylene glycol dimethacrylate and a monomer of glycidyl methacrylate (the mass ratio was 2:1) was introduced and vaporized at a vaporization temperature of 180°C and then was introduced into the chamber for plasma chemical vapor deposition. The flow rate of the mixture was 110µL/min. Plasmas in the chamber were generated by a radio frequency discharge, and the output mode was pulse. The discharge power was 50W, the frequency was 45Hz, the pulse duty cycle was 45%, and the discharge duration time was 3000s.

Thereafter, a mixture of a monomer of 1,3-butanediol dimethacrylate and a monomer of 2-phenoxyethyl acrylate (the mass ratio was 1:2) was introduced and vaporized at a vaporization temperature of 180°C and then was introduced into the chamber for plasma chemical vapor deposition. The flow rate of the mixture was 250µL/min. Plasmas in the chamber were generated by a radio frequency discharge, and the output mode was pulse. The discharge power was 26W, the frequency was 85Hz, the pulse duty cycle was 25%, and the discharge duration time was 7200s.

Thereafter, a monomer of 2-(perfluorohexyl) ethyl methacrylate was introduced and vaporized at a vaporization temperature of 120°C and then was introduced into the chamber for plasma chemical vapor deposition. The flow rate of the monomer was 100µL/min. Plasmas in the chamber were generated by a radio frequency discharge, and the output mode was pulse. The discharge power was 90W, the frequency was 65Hz, the pulse duty cycle was 65%, and the discharge duration time was 1800s.

After coating, the compressed air was introduced to restore the chamber to normal pressure. The circuit board was taken out for the 20.5 V underwater power-on test. The Mg sheet and the Fe sheet were taken out for the salt spray test. The test results are listed in Table 1.

### Embodiment 3

A circuit board, a Mg sheet and a Fe sheet were placed in a plasma chamber, the chamber was vacuumized to 80mTorr, and helium gas was introduced at a flow rate of 160sccm. A radio frequency plasma discharge was turned on to pretreat the substrates, the discharge power in this pretreatment stage was 180W, and the discharge duration time was 300s.

Thereafter, a mixture of a monomer of 1,6-hexanediol diacrylate and a monomer of 3,4-epoxycyclohexylmethacrylate (the mass ratio was 2:1) was introduced and vaporized at a vaporization temperature of 180°C and then was introduced into the chamber for plasma chemical vapor deposition. The flow rate of the mixture was 200µL/min. Plasmas in the chamber were generated by a radio frequency discharge, and the output mode was pulse. The discharge power was 50W, the frequency was 50Hz, the pulse duty cycle was 45%, and the discharge duration time was 2400s.

Thereafter, a mixture of a monomer of 1,6-hexanediol diacrylate and a monomer of phenyl acrylate (the mass ratio was 3:2) was introduced and vaporized at a vaporization temperature of 180°C and then was introduced into the chamber for plasma chemical vapor deposition. The flow rate of the mixture was 280µL/min. Plasmas in the chamber were generated by a radio frequency discharge, and the output mode was pulse. The discharge power was 20W, the frequency was 50Hz, the pulse duty cycle was 15%, and the discharge duration time was 3000s.

Thereafter, a monomer of 2-(perfluorohexyl) ethyl methacrylate was introduced and vaporized at a vaporization temperature of 120°C and then was introduced into the chamber for plasma chemical vapor deposition. The flow rate of the monomer was 160µL/min. Plasmas in the chamber were generated by a radio frequency discharge, and the output mode was pulse. The discharge power was 180W, the frequency was 50Hz, the pulse duty cycle was 15%, and the discharge duration time was 2600s.

After coating, the compressed air was introduced to restore the chamber to normal pressure. The circuit board was taken out for the 20.5 V underwater power-on test. The Mg sheet and the Fe sheet were taken out for the salt spray test. The test results are listed in Table 1. The electrochemical test was conducted on a coated Mg sheet and an uncoated Mg sheet, a Tafel curve was obtained and is shown in FIG. 1, and the electrochemical parameter results obtained by fitting this curve are listed in Table 2.

### Embodiment 4

A circuit board, a Mg sheet and a Fe sheet were placed in a plasma chamber, the chamber was vacuumized to 80mTorr, and helium gas was introduced at a flow rate of 120sccm. A radio frequency plasma discharge was turned on to pretreat the substrates, the discharge power in this pretreatment stage was 500W, and the discharge duration time was 300s.

Thereafter, a mixture of a monomer of neopentyl glycol dimethacrylate and a monomer of 3,4-epoxycyclohexylmethyl-3,4-epoxycyclohexylcarboxylate (the mass ratio was 2:1) was introduced and vaporized at a vaporization temperature of 160°C and then was introduced into the chamber for plasma chemical vapor deposition. The flow rate of the mixture was 300µL/min. Plasmas in the chamber were generated by a radio frequency discharge, and the output mode was pulse. The discharge power was 80W, the frequency was 25Hz, the pulse duty cycle was 50%, and the discharge duration time was 3600s.

Thereafter, a mixture of a monomer of neopentyl glycol dimethacrylate and a monomer of diallyl terephthalate (the mass ratio was 2:1) was introduced and vaporized at a vaporization temperature of 180°C and then was introduced into the chamber for plasma chemical vapor deposition. The flow rate of the mixture was 400µL/min. Plasmas in the chamber were generated by a radio frequency discharge, and the output mode was pulse. The discharge power was 100W, the frequency was 45Hz, the pulse duty cycle was 45%, and the discharge duration time was 3600s.

Thereafter, a monomer of 2-(perfluorododecyl) ethyl acrylate was introduced and vaporized at a vaporization temperature of 130°C and then was introduced into the chamber for plasma chemical vapor deposition. The flow rate of the monomer was 150µL/min. Plasmas in the chamber were generated by a radio frequency discharge, and the output mode was pulse. The discharge power was 150W, the frequency was 35Hz, the pulse duty cycle was 50%, and the discharge duration time was 5400s.

After coating, the compressed air was introduced to restore the chamber to normal pressure. The circuit board was taken out for the 20.5 V underwater power-on test. The Mg sheet and the Fe sheet were taken out for the salt spray test. The test results are listed in Table 1.

### Comparative Embodiment 1

A circuit board, a Mg sheet and a Fe sheet were placed in a plasma chamber, the chamber was vacuumized to 80mTorr, and helium gas was introduced at a flow rate of 160sccm. A radio frequency plasma discharge was turned on to pretreat the substrates, the discharge power in this pretreatment stage was 180W, and the discharge duration time was 300s.

Thereafter, a mixture of a monomer of 1,6-hexanediol diacrylate and a monomer of phenyl acrylate (the mass ratio was 3:2) was introduced and vaporized at a vaporization temperature of 180°C and then was introduced into the chamber for plasma chemical vapor deposition. The flow rate of the mixture was 280µL/min. Plasmas in the chamber were generated by a radio frequency discharge, and the output mode was pulse. The discharge power was 20W, the frequency was 50Hz, the pulse duty cycle was 15%, and the discharge duration time was 5400s.

Thereafter, a monomer of 2-(perfluorohexyl) ethyl methacrylate was introduced and vaporized at a vaporization temperature of 120°C and then was introduced into the chamber for plasma chemical vapor deposition. The flow rate of the monomer was 160µL/min. Plasmas in the chamber were generated by a radio frequency discharge, and the output mode was pulse. The discharge power was 180W, the frequency was 50Hz, the pulse duty cycle was 15%, and the discharge duration time was 2600s.

After coating, the compressed air was introduced to restore the chamber to normal pressure. The circuit board was taken out for the 20.5 V underwater power-on test. The Mg sheet and the Fe sheet were taken out for the salt spray test. The test results are listed in Table 1.

### Comparative Embodiment 2

A circuit board, a Mg sheet and a Fe sheet were placed in a plasma chamber, the chamber was vacuumized to 40mTorr, and helium gas was introduced at a flow rate of 60sccm. A plasma discharge was turned on to pretreat the substrates, the discharge power in this pretreatment stage was 150W, and the discharge duration time was 600s.

Thereafter, a mixture of a monomer of 1,4-butanediol diacrylate and a monomer of tetrahydrofurfuryl acrylate (the mass ratio was 2:1) was introduced and vaporized at a vaporization temperature of 100°C and then was introduced into the chamber for plasma chemical vapor deposition. The flow rate of the mixture was 150µL/min. Plasmas in the chamber were generated by a radio frequency discharge, and the output mode was pulse. The discharge power was 50W, the frequency was 45Hz, the pulse duty cycle was 25%, and the discharge duration time was 3600s.

Thereafter, a monomer of 1,6-hexanediol diacrylate was introduced and vaporized at a vaporization temperature of 120°C and then was introduced into the chamber for plasma chemical vapor deposition. The flow rate of the monomer was 100µL/min. Plasmas in the chamber were generated by a radio frequency discharge, and the output mode was pulse. The discharge power was 20W, the frequency was 25Hz, the pulse duty cycle was 65%, and the discharge duration time was 7200s.

Thereafter, a monomer of 3-(perfluoro-5-methylhexyl)-2-hydroxypropyl methacrylate was introduced and vaporized at a vaporization temperature of 120°C and then was introduced into the chamber for plasma chemical vapor deposition. The flow rate of the monomer was 100µL/min. Plasmas in the chamber were generated by a radio frequency discharge, and the output mode was pulse. The discharge power was 180W, the frequency was 35Hz, the pulse duty cycle was 45%, and the discharge duration time was 7200s.

After coating, the compressed air was introduced to restore the chamber to normal pressure. The circuit board was taken out for the 20.5 V underwater power-on test. The Mg sheet and the Fe sheet were taken out for the salt spray test. The test results are listed in Table 1.

**Table 1 Performance Test Results of Embodiments 1-4 and Comparative Embodiments 1-2**

| Coating Performance Test | | | | | | | | | |
|---|---|---|---|---|---|---|---|---|---|
| Embodi ment / Compara tive Embodi ment | 20.5 V Underwater Power-on Test | | | Salt Spray Test (5% NaCl solution) | | | | | |
| | substrate | thickness (nm) | time | substrate | thickness (nm) | time | substrate | thickness (nm) | time |
| Embodi ment 1 | circuit board | 255 | 5h52min | Fe | 100 | 82h | Mg | 137 | 56h |
| Embodi ment 2 | circuit board | 260 | 5hl5min | Fe | 125 | 84h | Mg | 125 | 60h |
| Embodi ment 3 | circuit board | 273 | 6h15min | Fe | 98 | 96h | Mg | 100 | 72h |
| Embodi ment 4 | circuit board | 252 | 4h40min | Fe | 108 | 74h | Mg | 107 | 50h |
| Compara tive Embodi ment 1 | circuit board | 264 | 3h20min | Fe | 115 | 60h | Mg | 105 | 38h |
| Compara tive Embodi ment 2 | circuit board | 260 | 2h40min | Fe | 105 | 42h | Mg | 132 | 24h |

**Table 2 Electrochemical Parameter Test Results of Embodiments 3**

| Embodiment | substrate | coating thickness (nm) | current density (A/cm²) | corrosion potential (V) |
|---|---|---|---|---|
| Embodiment 3 | Mg | 100 | 1.876e⁻⁹ | -1.128 |
| | | 0 | 5.322e⁻⁵ | -1.385 |

From the performance test results of Embodiments 1-4 and Comparative Embodiments 1-2 in Table 1 above, it could be seen that Embodiments 1-4 have obvious advantages in the 20.5V underwater power-on test duration time and the salt spray test duration time compared with comparative Embodiments 1-2. The performance test results show that the composite coating of the present disclosure including a base coating and an anti-corrosion coating and being of an ultra-thin thickness has an excellent protective performance. The base coating was formed from a plasma of the multifunctional-group ester-based monomer having an epoxy structure and a plasma of the ester-based coupling agent, and the anti-corrosion coating was formed from a plasma of an unsaturated ester-based monomer having aromatic ring(s) and a plasma of an ester-based coupling agent. In the meantime, Embodiments 1-3 had longer duration time in the 20.5V underwater power-on test and the salt spray test compared with Embodiment 4, indicating that when the multifunctional-group ester having an epoxy structure in the base coating is an enolate ester structure, the composite coating has a better protective performance.

From the electrochemical parameters test results of Embodiment 3 in Table 2 above, it could be seen that, the uncoated Mg sheet in the 3.6% NaCl neutral solution had a very poor corrosion resistance, and an electrochemical corrosion occurred. The anodic reaction was a dissolution process of magnesium which lost electrons, and the cathodic reaction was a hydrogen evolution process from water which got electrons. It was found in the experiments that a corrosion potential of the uncoated Mg sheet was -1.385V, and a corrosion potential of the coated Mg sheet was -1.128V, indicating that the corrosion potential was reduced by 23% due to the coating, and the corrosion resistance was enhanced. A current density of the coated Mg sheet was 1.876e⁻⁹A/cm². Compared with the uncoated Mg sheet, the current density of the coated Mg sheet was reduced by 4 orders of magnitude, indicating that the coated Mg sheet had an excellent protective performance.

Although the present disclosure has been disclosed above, the disclosure is not limited hereto. Those skilled in the art can modify and vary the embodiments without departing from the spirit and scope of the present disclosure. Therefore, the scope of protection of the present disclosure shall be subject to the scope defined in claims.

## Claims

1. A composite coating, **characterized in that** the composite coating comprises a coating I and a coating II deposited on a substrate,
wherein the coating I is a plasma polymerization coating formed from plasmas comprising a monomer α and a monomer β;
wherein the coating II is a plasma polymerization coating formed on the coating I by contacting the coating I with plasmas comprising a monomer γ and a monomer δ;
wherein a structure of the monomer α is shown as in formula (1-1), 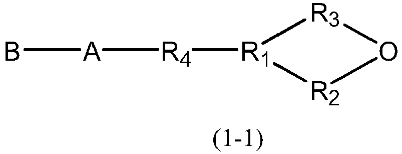
wherein R₁ is selected from CH or a C₃-C₈ cycloalkyl, R₂, R₃ and R₄ are respectively independently selected from a connecting bond or a C₁-C₆ alkylene, R₂ and R₃ are not connected to a same carbon atom when R₂ and R₃ are both connecting bonds, A is a connecting part, and B comprises a carbon-carbon unsaturated bond or an epoxy structure;
wherein a structure of the monomer β is shown as in formula (2-1), 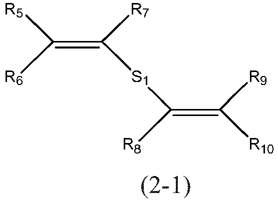
wherein S₁ comprises at least one -O-C(O)- or -C(O)-O-, and R₅, R₆, R₇, R₈, R₉ and R₁₀ are respectively independently selected from a group consisting of a hydrogen atom, a halogen atom, a C₁-C₁₀ alkyl and a halogen-substituted C₁-C₁₀ alkyl;
wherein a structure of the monomer γ is shown as in formula (3-1), 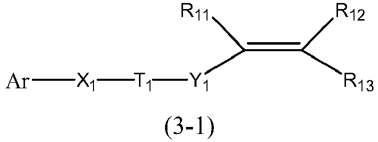
wherein Ar is a structure with aromatic ring(s), T₁ is -O-C(O)- or -C(O)-O-, X₁ is a connecting part, Y₁ is a connecting part, and R₁₁, R₁₂ and R₁₃ are respectively independently selected from a group consisting of a hydrogen atom, a halogen atom, a C₁-C₁₀ alkyl and a halogen-substituted C₁-C₁₀ alkyl; and
wherein a structure of the monomer δ is shown as in formula (4-1), 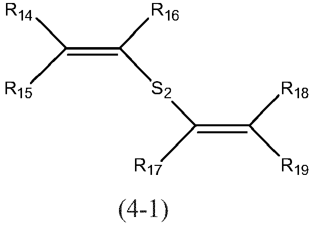 wherein S₂ comprises at least one -O-C(O)- or -C(O)-O-, and R₁₄, R₁₅, R₁₆, R₁₇, R₁₈ and R₁₉ are respectively independently selected from a group consisting of a hydrogen atom, a halogen atom, a C₁-C₁₀ alkyl and a halogen-substituted C₁-C₁₀ alkyl.

2. The composite coating according to claim 1, **characterized in that** the A is -O-C(O)-or -C(O)-O-.

3. The composite coating according to claim 2, **characterized in that** a structure of the monomer α is shown as in formula (1-2), 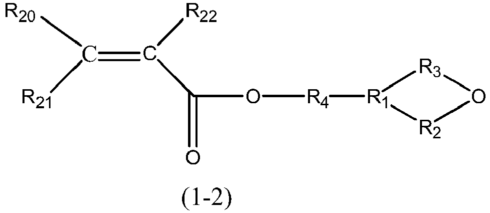 wherein R₂₀, R₂₁ and R₂₂ are respectively independently selected from a group consisting of a hydrogen atom, a halogen atom, a C₁-C₁₀ alkyl and a halogen-substituted C₁-C₁₀ alkyl.

4. The composite coating according to claim 1, **characterized in that** the R₅, R₆, R₇, R₈, R₉, R₁₀, R₁₁, R₁₂, R₁₃, R₁₄, R₁₅, R₁₆, R₁₇, R₁₈ and R₁₉ are respectively independently selected from a group consisting of a hydrogen atom and a methyl.

5. The composite coating according to claim 3, **characterized in that** the R₂₀, R₂₁ and R₂₂ are respectively independently selected from a group consisting of a hydrogen atom and a methyl.

6. The composite coating according to claim 1, **characterized in that** the monomer α comprises one or more selected from a group consisting of glycidyl methacrylate, tetrahydrofurfuryl acrylate, 3,4-epoxycyclohexylmethyl-3,4-epoxycyclohexylcarboxylate, 3,4-epoxy cyclohexylmethacrylate, 3,4-epoxycyclohexylmethylmethacrylate, 1,2-epoxy-4-vinylcyclohexane, bis (2,3-epoxycyclopentyl) ether, 2,3-epoxycyclopentylcyclopentyl ether, vinylcyclohexene diepoxide, diisoprene diepoxide and bis ((3,4-epoxycyclohexyl) methyl) adipate.

7. The composite coating according to claim 1, **characterized in that** the S₁ and/or S₂ comprise(s) two -O-C(O)- or -C(O)-O-.

8. The composite coating according to claim 7, **characterized in that** a structure of the S₁ is shown as in formula (2-2), 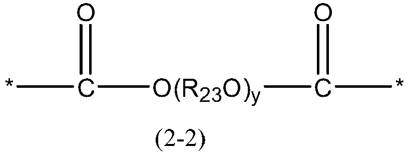 wherein R₂₃ is a C₂-C₁₀ alkylene or a halogen-substituted C₂-C₁₀ alkylene, and y is an integer ranging from 0 to 10.

9. The composite coating according to claim 1, **characterized in that** the monomer β comprises at least one selected from a group consisting of 1,4-butanediol dimethacrylate, 1,6-hexanediol dimethacrylate, ethylene glycol dimethacrylate, diethylene glycol dimethacrylate, triethylene glycol dimethacrylate, tetraethylene glycol dimethacrylate, 1,3-butanediol dimethacrylate, neopentyl glycol dimethacrylate, methacrylic anhydride, diprop-2-enyl-2-methylene succinate, diprop-2-enyl 2-benzylidene malonate, and diethyl diallyl malonate.

10. The composite coating according to claim 1, **characterized in that** a structure of the X₁ is shown as in formula (3-2), 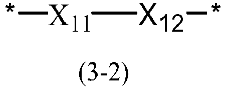
wherein X₁₁ is a connecting bond, -O- or -C(O)-, and X₁₂ is a connecting bond, a C₁-C₁₀ alkylene or a halogen-substituted C₁-C₁₀ alkylene; and
the Y₁ is a connecting bond, a C₁-C₁₀ alkylene or a halogen-substituted C₁-C₁₀ alkylene.

11. The composite coating according to claim 1, **characterized in that** the Ar is a benzene ring structure or a benzene ring structure with substituent(s).

12. The composite coating according to claim 11, **characterized in that** a structure of the monomer γ is shown as in formula (3-3), 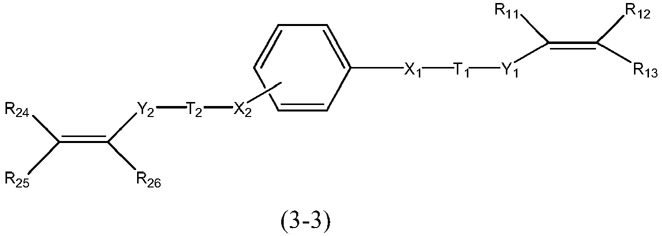 wherein T₂ is -O-C(O)- or -C(O)-O-, X₂ is a connecting part, Y₂ is a connecting part, and R₂₄, R₂₅ and R₂₆ are respectively independently selected from a group consisting of a hydrogen atom, a halogen atom, a C₁-C₁₀ alkyl and a halogen-substituted C₁-C₁₀ alkyl.

13. The composite coating according to claim 12, **characterized in that** a structure of the X₂ is shown as in formula (3-4), 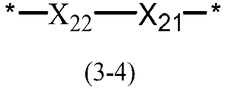
wherein X₂₁ is a connecting bond, -O- or -C(O)-, and X₂₂ is a connecting bond, a C₁-C₁₀ alkylene or a halogen-substituted C₁-C₁₀ alkylene; and
the Y₂ is a connecting bond, a C₁-C₁₀ alkylene or a halogen-substituted C₁-C₁₀ alkylene.

14. The composite coating according to claim 12, **characterized in that** the R₂₄, R₂₅ and R₂₆ are respectively independently selected from a group consisting of a hydrogen atom and a methyl.

15. The composite coating according to claim 1, **characterized in that** the monomer γ comprises at least one selected from a group consisting of 2-phenoxyethyl acrylate, phenyl acrylate, diallyl terephthalate and phenyl methacrylate.

16. The composite coating according to claim 7, **characterized in that** a structure of the S₂ is shown as in formula (4-2), 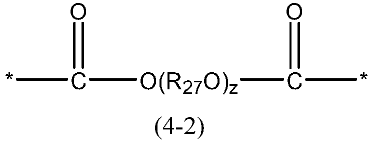 wherein R₂₇ is a C₂-C₁₀ alkylene or a halogen-substituted C₂-C₁₀ alkylene, and z is an integer ranging from 0 to 10.

17. The composite coating according to claim 1, **characterized in that** the monomer δ comprises at least one selected from a group consisting of 1,4-butanediol dimethacrylate, 1,6-hexanediol dimethacrylate, ethylene glycol dimethacrylate, diethylene glycol dimethacrylate, triethylene glycol dimethacrylate, tetraethylene glycol dimethacrylate, 1,3-butanediol dimethacrylate, neopentyl glycol dimethacrylate, methacrylic anhydride, dipropyl-2-allyl-2-methylene succinate, diprop-2-enyl 2-benzylidene malonate, and diethyl diallyl malonate.

18. The composite coating according to claim 1, **characterized in that** the composite coating further comprises a coating III, wherein the coating III is a plasma polymerization coating formed on the coating II by contacting the coating II with plasmas comprising a monomer ε; and a structure of the monomer ε is shown as in formula (5-1), 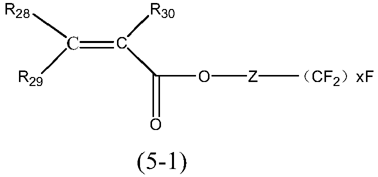 wherein Z is a connecting part, R₂₈, R₂₉ and R₃₀ are respectively independently selected from a group consisting of a hydrogen atom, a halogen atom, a C₁-C₁₀ hydrocarbyl and a halogen-substituted C₁-C₁₀ hydrocarbyl, and x is an integer ranging from 1 to 20.

19. The composite coating according to claim 18, **characterized in that** the Z is a connecting bond, a C₁-C₄ alkylene or a C₁-C₄ alkylene with substituent(s), and x is an integer greater than or equal to 5.

20. The composite coating according to claim 18, **characterized in that** the R₂₈, R₂₉ and R₃₀ are respectively independently selected from a group consisting of a hydrogen atom and a methyl.

21. The composite coating according to claim 18, **characterized in that** the monomer ε comprises one or more selected from a group consisting of: 3-(perfluoro-5-methylhexyl)-2-hydroxypropyl methacrylate, 2-(perfluorodecyl) ethyl methacrylate, 2-(perfluorohexyl) ethyl methacrylate, 2-(perfluorododecyl) ethyl acrylate, 2-perfluorooctyl ethyl acrylate, 1H,1H,2H,2H-perfluorooctyl acrylate, 2-(perfluorobutyl) ethyl acrylate, (2H-perfluoropropyl)-2-acrylate, and (perfluorocyclohexyl) methacrylate.

22. The composite coating according to claim 1, **characterized in that** a thickness of the composite coating ranges from 50nm to 300nm.

23. The composite coating according to claim 1, **characterized in that** a molar ratio of the monomer α and the monomer β ranges from 1:5 to 5:1.

24. The composite coating according to claim 1, **characterized in that** a molar ratio of the monomer γ and the monomer δ ranges from 3:10 to 10:3.

25. The composite coating according to claim 1, **characterized in that** the substrate is a metal, a plastic, a fabric, a glass, an electrical assembly, an optical instrument or an electrical component.

26. A preparation method of the composite coating as claimed in any one of claims from claim 1 to claim 25, **characterized by** comprising:
providing a substrate, placing the substrate in a plasma reaction chamber, vacuumizing the plasma reaction chamber to get a vacuum degree in the plasma reaction chamber ranging from 20mTorr to 200mTorr, and introducing one or more gases selected from a group consisting of inert gas He, inert gas Ar, and O₂;
introducing mixed vapors comprising the monomer α and the monomer β into the plasma reaction chamber, and turning on a plasma discharge to form a plasma polymerization coating I; and
introducing mixed vapors comprising the monomer γ and the monomer δ into the plasma reaction chamber, and turning on a plasma discharge to form a plasma polymerization coating II on the coating I.

27. The preparation method according to claim 26, **characterized by** comprising:
introducing a vapor of the monomer ε into the plasma reaction chamber, and turning on a plasma discharge to form a plasma polymerization coating III on the coating II.

28. The preparation method according to claim 26, **characterized in that** the plasma is a pulse plasma.

29. The preparation method according to claim 28, **characterized in that** the pulse plasma is generated by applying a pulse voltage discharge, wherein a pulse power ranges from 50W to 500W, a pulse frequency ranges from 25Hz to 85kHz, a pulse duty cycle ranges from 5% to 85%, and a plasma discharge duration time ranges from 100s to 36000s.

30. A device, **characterized in that** at least a part of a surface of the device is provided with the composite coating as claimed in any one of claims from claim 1 to claim 25.
